# EUROPEAN PATENT APPLICATION

(11) **EP 4 670 910 A1**
(43) Date of publication of application: **31.12.2025**
(21) Application number: 23924130.0
(22) Date of filing: 27.07.2023
(51) Int. Cl.: B24B 7/04, C30B 33/06, C30B 29/36, H01L 21/304

(54) **METHOD FOR GRINDING SEMICONDUCTOR CRYSTAL AND METHOD FOR PRODUCING SIC EXTENDED INGOT USING SAID GRINDING METHOD**

(30) Priority: 24.02.2023 JP 2023027465; 29.03.2023 JP 2023052511
(71) Applicant: Success Co., Ltd., Noda-shi Chiba 278-0022 (JP); Drychemicals Co., Ltd., Natori-shi, Miyagi 981-1238 (JP)
(72) Inventor: Sakai, Shinsuke, Noda-shi, Chiba 278-0022 (JP); Chiba, Tetsuya, Natori-shi, Miyagi 981-1238 (JP)
(74) Representative: Papula Oy
(86) International application number: PCT/JP2023/027636
(87) International publication number: WO 2024/176485

(57) **Abstract**

The present invention provides: a method for grinding semiconductor crystal, the method being capable of achieving higher grinding accuracy by controlling plastic deformation, which has been abhorred in the past, as a plastic deformation mechanism of a semiconductor crystal ingot end surface or a wafer surface; and a method for producing SiC extended ingot, the method using the above-described grinding method. In a method for grinding an SiC wafer 100 according to the present invention, a plastic deformation region 100A is formed in a platen 52 (grinding plate)-side surface of the wafer 100 by a temperature increase caused by friction due to intervention of diamond abrasive grains 53 between the surface and a platen 52 on the basis of: (1) the grain size of the diamond abrasive grains 53 (diamond grindstones); (2) the pressing force that presses the wafer 100 against the platen 52 by the intermediary of a spindle 51; and (3) the advance rate of the spindle 51 with respect to the platen 52.

## Description

### TECHNICAL FIELD

The present invention relates to a method for grinding semiconductor crystal which grinds an end face of a semiconductor crystal ingot that has been ground into a cylindrical shape, or a surface of a wafer that has been cut into a slice shape from the semiconductor crystal ingot, and a method for producing SiC extended ingot using the grinding method.

### BACKGROUND ART

Conventionally, for a polishing platen used in a method of grinding this type of semiconductor crystal wafer as disclosed in Patent Literature 1 below, it is known that by setting the 0.2% yield strength of the material forming the main body thereof to 50 [kg/mm²] or more, a lapping surface (polishing surface) is less likely to be abraded and plastic deformation is less likely to occur.

### [Citation List]

### [Patent Literature]

Patent Literature 1: JPH08174407A

### SUMMARY OF INVENTION

### [Technical Problem]

As described above, in a conventional grinding method of a semiconductor crystal wafer, plastic deformation of the polishing platen and plastic deformation of the wafer itself should be eliminated from the viewpoint of improving grinding accuracy.

However, as a result of intensive studies by the inventors of the present invention, it has been found that higher grinding accuracy can be realized by controlling plastic deformation, which was abhorred in the past, as a plastic deformation mechanism in an end surface of a semiconductor crystal ingot or in a wafer surface.

Based on such findings, the present invention aims to provide a method of grinding a semiconductor crystal, in which higher grinding accuracy can be realized by controlling plastic deformation, which was abhorred in the past, as a plastic deformation mechanism in end surface of a semiconductor crystal ingot or in a wafer surface, and a method for producing SiC extended ingot using the grinding method.

### [Solution to Problem]

A method for grinding semiconductor crystal according to a first aspect of the present invention is a method for grinding semiconductor crystal which grinds an end face of a semiconductor crystal ingot that has been ground into a cylindrical shape, or a surface of a wafer that has been cut into a slice shape from the semiconductor crystal ingot, characterized in that,

When a plastic deformation region is formed in the end surface of the semiconductor crystal ingot on the grinding plate side or in a surface of the wafer on the grinding plate side by a temperature increase caused by friction due to intervention of a diamond grindstone between the surface and the grinding plate, on the basis of:
(1) the grain size of the diamond grindstone used for grinding;
(2) a pressing force with which the semiconductor crystal ingot or the wafer is pressed against a grinding plate via a support table; and
(3) an advance rate of the support table with respect to the grinding plate,
grain sizes exceeding the width of the plastic deformation region are not used as the grain size of the diamond grindstone, and the advance rate does not exceed the depth of the plastic deformation region.

According to the method for grinding semiconductor crystal of the first aspect of the present invention, a plastic deformation region is intentionally formed in an end face of the semiconductor crystal ingot on the grinding plate side or in a surface of the wafer on the grinding plate side by controlling (1) the grain size of a diamond grindstone used for grinding, (2) a pressing force with which the end face of the semiconductor crystal ingot or the surface of the wafer is pressed against the grinding plate via a support table, and (3) a advance rate of the support table with respect to the grinding plate.

In the plastic deformation region thus formed in the end face of the semiconductor crystal ingot or in the surface of the wafer, unlike surface polishing without plastic deformation, the grinding efficiency by the diamond grindstone is remarkably improved, and a mirror finish with high flatness can be realized at one time.

As described above, according to the method for grinding semiconductor crystal of the first aspect of the present invention, it is possible to provide a method for grinding semiconductor crystal capable of realizing higher grinding accuracy by controlling plastic deformation, which was abhorred in the past, as a plastic deformation mechanism in an end surface of a semiconductor crystal ingot or in a surface of the wafer.

A method for producing SiC extended ingot according to a second aspect of the present invention is a method for producing SiC extended ingot using the method for grinding semiconductor crystal according to the first aspect of the invention, in which single SiC ingots that have been ground into a cylindrical shape are bonded and extended in an axial direction, the method comprising:
a grinding step of grinding an end face of the single SiC ingot into a mirror surface; and
a bonding step of bonding end surfaces of the SiC ingots that have been ground into mirror surfacse by the grinding step;
wherein the single SiC ingots are extended in an axial direction by the bonding step,
the grinding step is characterized in that,
when a plastic deformation region is formed in an end surface of the SiC ingot on the grinding plate side by a temperature increase caused by friction due to intervention of a diamond grindstone between the surface and the grinding plate, on the basis of:
   (1) the grain size of the diamond grindstone used for grinding;
   (2) a pressing force with which the SiC ingot is pressed against the grinding plate via a support table; and
   (3) an advance rate of the support table with respect to the grinding plate,
grain sizes exceeding the width of the plastic deformation region are not used as the grain size of the diamond grindstone, and the advance rate does not exceed the depth of the plastic deformation region.

According to the method for producing SiC extended ingot of the second aspect of the present invention, since the single SiC ingots are extended by bonding together the end faces thereof, a desired extended ingot can be obtained by repeating the bonding without depending on the growth properties of the crystal itself.

Since the bonding here is a crystal bonding in which end surfaces ground into mirror surfaces with high grinding accuracy by a plastic deformation mechanism are bonded to each other, it is possible to realize strong bonding while being simple. Therefore, it is possible to obtain an ingot having excellent workability, and even when wafers are cut out from the elongated SiC extended ingot, it is possible to maintain its shape while performing cutting.

As described above, according to the method for producing SiC extended ingot of the second aspect of the present invention, an extended ingot can be obtained without depending on the growth properties of the crystal. Further, excellent workability can be realized while maintaining the quality of the crystal.

A method for producing SiC extended ingot according to a third aspect of the present invention is a method according to the second aspect of the present invention, wherein
the single SiC ingot has a notch cut into a side surface thereof; and
in the bonding step, the SiC ingots are extended by bonding end surfaces thereof which have been ground into mirror surfaces in a state where the notches are aligned with each other.

It is desirable from the viewpoint of workability that an extended ingot which is obtained by bonding and extending has a uniform outer diameter shape, and according to the method for producing SiC extended ingot of the third aspect of the present invention, by providing one or a plurality of notches on the side surface of the single SiC ingots and aligning the notches in a state where the notches are aligned with each other, the outer diameter shapes of the single SiC ingots can be aligned when the single SiC ingots are bonded to each other, and consequently, a SiC extended ingot having a uniform outer diameter shape can be obtained.

As described above, according to the method for producing SiC extended ingot of the third aspect of the present invention, it is possible to obtain an extended ingot without depending on the growth properties of the crystal. Further, it is possible to realize excellent workability while maintaining crystal quality.

### BRIEF DESCRIPTION OF THE DRAWINGS

FIG. 1 is a flowchart showing the entire method for producing SiC wafer (semiconductor crystal wafer) of the present embodiment.
FIG. 2 is an explanatory view showing a first surface machining step and a second surface machining step in the method for producing SiC wafer of FIG. 1.
FIG. 3 is an explanatory view showing a first surface machining step and a second surface machining step in the method for producing SiC wafer of FIG. 1.
FIG. 4 is a schematic view showing a machining state in a first surface machining step and a second surface machining step in the method for producing SiC wafer of FIG. 1.
FIG. 5A is a schematic view showing a machining state in a first surface machining step and a second surface machining step in the method for producing SiC wafer of FIG. 1.
FIG. 5B is a schematic view showing a machining state in a first surface machining step and a second surface machining step in a conventional method for producing SiC wafer.
FIG. 6 is an explanatory view showing a state in which wafers obtained by the first surface machining step and the second surface machining step in the method for producing SiC wafer of FIG. 1 are crystal-bonded to each other.

### DESCRIPTION OF EMBODIMENTS

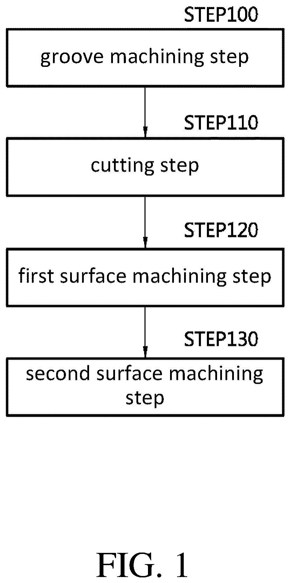

As shown in FIG. 1, in the present embodiment, the method for producing a SiC wafer, which is a semiconductor crystal wafer, is a method of obtaining a SiC wafer by removing undulations on one surface of a wafer that has been cut into a slice shape from a cylindrically ground SiC ingot, and the method includes a groove machining step (STEP 100/FIG. 1), a cutting step (STEP 110/FIG. 1), a first surface machining step (STEP 120/FIG. 1), and a second surface machining step (STEP 130/FIG. 1).

The machining in the first surface machining step of STEP 120 and the second surface machining step of STEP 130, i.e., mechanical polishing (high-precision grinding) corresponds to the semiconductor crystal wafer grinding method of the present invention (the characteristic grinding and grinding step of the present invention). Besides, since the groove machining step of STEP 100 and the cutting step of STEP 110 are described in Japanese Patent Nos. 7104909 and 7100864 filed by the same applicant as the present application, detailed description thereof will be omitted, and only an outline will be described below.

First, in the groove machining step of STEP 100, a cylindrical SiC ingot is prepared by subjecting a pre-crystallized SiC crystal to cylindrical grinding with a determined crystal orientation in an ingot machining step.

Then, in the groove machining step of STEP 100, a plurality of concave grooves are formed around the entire side surface of the SiC ingot.

Specifically, in the groove machining step of STEP 100, while the groove machining drum grindstone, which has convex portions corresponding to the concave grooves formed in the entire side surface, and the SiC ingot are respectively rotated on rotation shafts parallel to each other, the groove machining drum grindstone is pressed against the SiC ingot to thereby form the concave grooves.

In addition, it is desirable to perform damage-free mirror finish machining on the SiC ingot (particularly, the concave grooves) obtained by the groove machining step by a chemical processing method.

Next, in the cutting step of STEP 110, the SiC ingot is cut into slices by a plurality of wires arranged in the plurality of concave grooves formed in the groove machining step to obtain SiC wafers 100.

Specifically, in the cutting step, a wire saw device, which is a cutting device, cuts the SiC ingot into slices by causing a wire saw portion to fit the plurality of wires into the plurality of concave grooves formed in the groove machining step, respectively, and advancing the wires while circulating the wires.

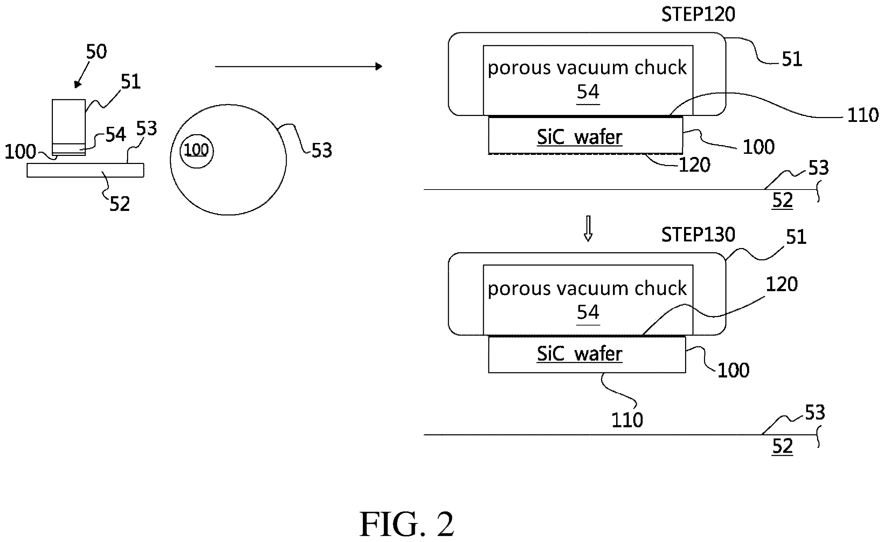

Next, as shown in FIG. 2, in the first surface machining step of STEP 120, one surface 110 of the cut surface is used as a support surface, and the other surface 120 is subjected to mechanical polishing (high-precision grinding).

Specifically, in the first surface machining step, grinding is performed by a mechanical polishing device 50 (ultra-high synthetic high-precision grinding apparatus) that performs mechanical polishing.

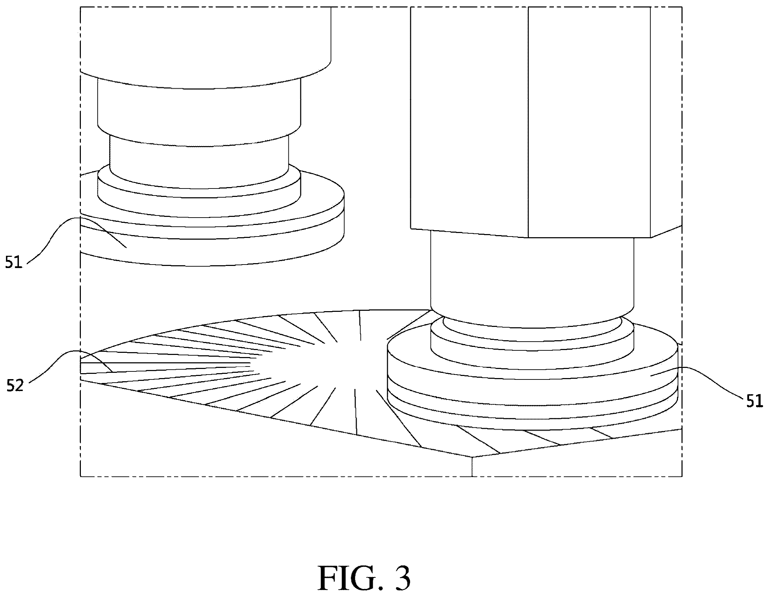

As shown in FIG. 3, the mechanical polishing device 50 includes a spindle 51 and a platen 52 serving as a grinding plate, and diamond abrasive grains 53 are provided on the platen 52. The platen 52 has a concave-convex structure in which a radial groove portion is provided on the polishing surface, and a plane region of the convex portion is larger than that of the concave grooves, and such a structure contributes to a temperature increase cause by friction as described later.

First, one surface 110 of the SiC wafer 100 faces upward and is sucked to and supported by a porous vacuum chuck 54 that is a suction plate of the spindle 51 which is a support table supporting the wafer, and the other surface 120 faces downward and is ground with the diamond abrasive grains 53.

At this time, the spindle 51 and the platen 52 are rotationally driven by a driving device (not shown), and the other surface 120 is ground by pressing the spindle 51 against the platen 52 via a compressor or the like (not shown).

After the grinding, the diamond abrasive grains 53 may be dressed by a dresser or the like.

In addition, the mechanical polishing device 50 may include functional water supply pipes so that a plurality of functional waters can be used during machining as necessary.

Next, in the second surface machining step of STEP 130, the other surface 120 which has been subjected to the high-precision grinding process in the first surface machining step is directed upward, and the same high-precision grinding process as in the first surface machining step is performed in the one surface 110.

That is, the other surface 120 is facing upward and sucked to and supported by the porous vacuum chuck 54 which is the suction plate of the spindle 51, and the one side 110 is facing downward and ground with the diamond abrasive grains 53.

In this case, the dresser or the like can also be pressed against the diamond abrasive grains 53 to perform dressing as necessary.

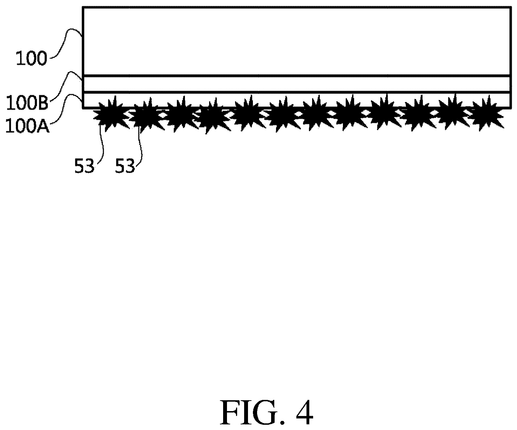

In the present embodiment, particularly, as shown in FIG. 4, during the mechanical polishing (high-precision grinding) process in the first surface machining step of STEP 120 and second surface machining step of STEP 130, a plastic deformation region 100A is formed in the surface of the wafer 100 on the platen 52 (grinding plate) side by a temperature increase (for example, 700°C or more but lower than the melting point) caused by friction due to intervention of the diamond abrasive grains 53 between the surface and the platen 52, on the basis of:
(1) the grain size of diamond abrasive grains (diamond grindstone) 53 used for grinding;
(2) a pressing force with which the wafer 100 is pressed against the platen 52 via the spindle 51; and
(3) an advance rate of the spindle 51 with respect to the platen 52.

That is, the plastic deformation region 100A is intentionally formed in the surface of the wafer 100 on the platen 52 side by controlling:
(1) the grain size of the diamond abrasive grains 53 used for grinding (for example, for SiC wafers, #1000-5000, more preferably #1500-4000);
(2) the pressing force with which the wafer 100 is pressed against the platen 52 via the spindle 51 (hundreds g/cm² that is greater than the usually applied pressure of less than 100 g/cm², e.g., 200 g/cm²-800 g/cm² for SiC wafers); and
(3) the advance rate of the spindle 51 with respect to the platen 52 (in the case of the SiC wafer, a few tenths of µm to tens of µm/min).

In the drawings, an intermediate region 100B is a region in an intermediate state between the plastically deformed state and the original state (elastic state) of the wafer 100.

In the plastic deformation region 100A formed in this manner on the surface of the wafer 100, unlike surface grinding without plastic deformation, the grinding efficiency by the diamond abrasive grains 53 is remarkably improved, and a mirror finish with high flatness can be realized at one time. That is, the complicated manufacturing steps such as polishing once to four times can be greatly simplified.

Here, it is important that (3) the advance rate of the spindle 51 with respect to the platen 52 is controlled not to exceed the depth of the plastic deformation region.

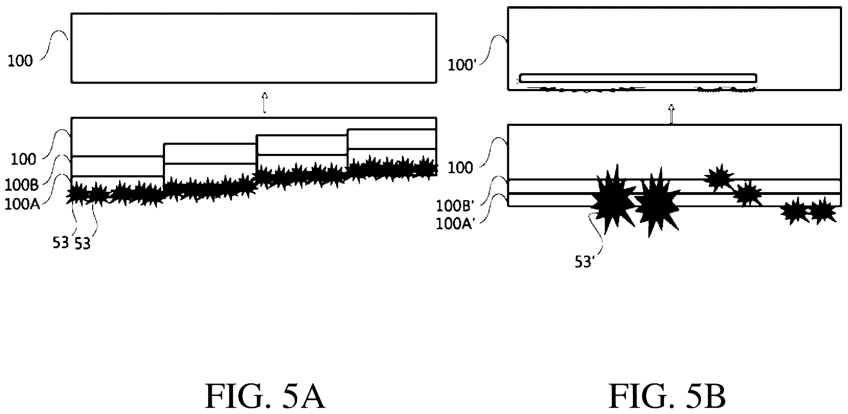

As schematically shown in FIG. 5A, by controlling (3) the advance rate of the spindle 51 with respect to the platen 52 so as not to exceed the depth of the plastic deformation region 100A, that is, by constantly keeping the plastic deformation region 100A on the surface of the wafer 100 (of course, it is assumed that the grain size of the diamond abrasive grains 53 exceeding the depth of the plastic deformation region 100A (the thickness of the layer of the plastic deformation region 100A, which is synonymous with the depth of the plastic deformation region 100A) is not adopted), it is possible to realize a mirror finish with high flatness by the diamond abrasive grains 53 at one time while continuously forming the plastic deformation region 100A.

On the other hand, as schematically shown in FIG. 5B, if the grain size of the diamond abrasive grains 53' exceeds the depth of the plastic deformation region 100A (left side in the figure) or if the advance rate of the spindle 51 with respect to the platen 52 is advanced beyond the depth of the plastic deformation region 100A (right side in the figure), propagation of a crack or the like occurs and the wafer 100' has a machine-damaged layer after machining.

As described above, according to the method of grinding a SiC wafer, which is a semiconductor crystal wafer of the present embodiment, it is possible to actually provide a method of grinding a semiconductor crystal wafer that can realize higher grinding accuracy by controlling plastic deformation, which was abhorred in the past, as a plastic deformation mechanism of a wafer surface.

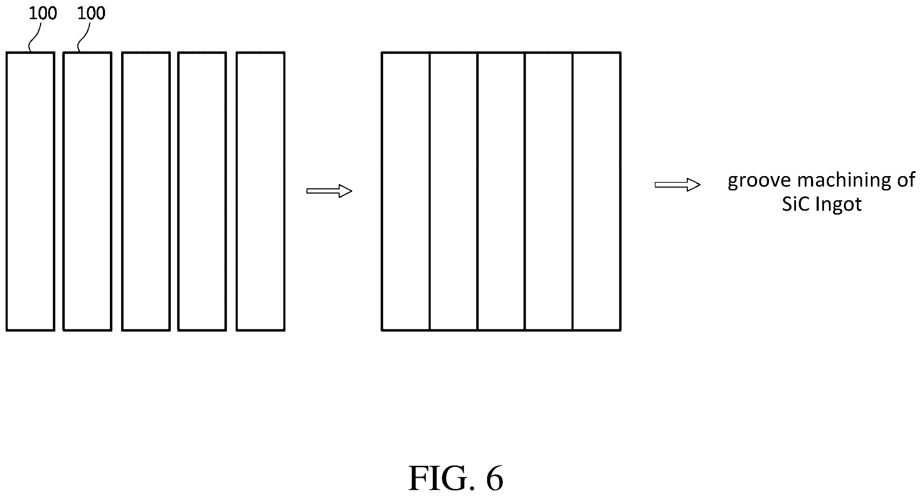

According to the method of grinding SiC wafer of the present embodiment, since the wafer 100 after grinding has a mirror finish with high flatness, as shown in FIG. 6, the wafer 100 can be extended by crystal bonding the mirror surfaces of the wafer 100 (strong adhesion of the mirror-polished metal surfaces).

Here, the crystal bonding (strong adhesion of the mirror-polished metal surfaces) is not limited to the wafer 100, and may be applied to end faces of various semiconductor crystal ingots. In particular, in a case where it is difficult to obtain a extended SiC ingot with low crystal growth, the end surfaces of the SiC ingot are ground to mirror surfaces by the above-described grinding method, so that the end surfaces of the SiC ingot ground to mirror surfaces can be bonded to each other and extended.

Then, by subjecting the SiC extended ingot thus obtained to the above-described series of machining in STEP100 to STEP130, it is possible to obtain a SiC wafer in which mirror finish with high flatness is realized at one time.

That is, since the end faces of the single SiC ingots are bonded to each other and extended, a desired extended ingot can be obtained by repeating the bonding without depending on the growth properties of the crystal itself.

Further, since the bonding here is a crystal bonding in which end faces ground to mirror surfaces having a high flatness are bonded to each other, it is possible to realize a strong bonding while being simple. Therefore, it is possible to obtain an ingot having excellent workability, and even when wafers are cut out from the elongated SiC extended ingot, its shape can be maintained while performing cutting.

When the end surfaces of the SiC ingot are bonded to each other and extended, it is preferable that a notch is formed by cutting into side surface of a single SiC ingot, and when a plurality of the SiC ingots are bonded to each other, the end surfaces ground to mirror surfaces are bonded to each other and extended in a state in which a plurality of the notches are aligned.

As a result, the outer diameters of the bonded SiC ingots can be made uniform, and a SiC extended ingot having a uniform outer diameter dimension without deviating from the central axis line can be obtained.

That is, it is desirable from the viewpoint of workability that the outer diameter shape of the extended ingot which is obtained by bonding and extending is uniform; one or a plurality of notches are provided on the side surface of the single SiC ingot, and by aligning the notches, the outer diameter shapes of the single SiC ingots can be aligned when the single SiC ingots are bonded to each other; and consequently, a SiC extended ingot having a uniform outer diameter shape can be obtained.

As described above, by applying the SiC extended ingot and the method for producing SiC extended ingot, it is possible to obtain an elongated ingot without depending on the growth properties of the rystal. Further, it is possible to realize excellent workability while maintaining crystal quality.

In addition, in the present embodiment, as a method of grinding SiC wafer, a case where a SiC wafer is produced from a SiC ingot has been described, but the semiconductor crystal is not limited to SiC, and may be a compound semiconductor such as gallium arsenide, indium phosphide, silicon, or the like.

### REFERENCE SIGNS LIST

50 mechanical polishing device (ultra-high synthetic high-precision grinding apparatus)
51 spindle
52 platen
53 diamond abrasive grains
54 porous vacuum chuck (suction plate)
100, 100' SiC wafer (semiconductor crystal wafer)
100A, 100A' plastic deformation region
100B, 100B' intermediate region
110 one surface
120 the other surface
STEP 100 groove machining step
STEP 110 cutting step
STEP 120 first surface machining step
STEP 130 second surface machining step

## Claims

1. A method for grinding semiconductor crystal, which grinds an end face of a semiconductor crystal ingot that has been ground into a cylindrical shape, or a surface of a wafer that has been cut into a slice shape from the semiconductor crystal ingot, the method being **characterized in that**,
when a plastic deformation region is formed in an end surface of the semiconductor crystal ingot on the grinding plate side or in a surface of the wafer on the grinding plate side by a temperature increase caused by friction due to intervention of a diamond grindstone between the surface and the grinding plate, on the basis of:
(1) the grain size of the diamond grindstone used for grinding,
(2) a pressing force with which the semiconductor crystal ingot or the wafer is pressed against a grinding plate via a support table, and
(3) an advance rate of the support table with respect to the grinding plate,
grain sizes exceeding the width of the plastic deformation region are not used as the grain size of the diamond grindstone, and the advance rate does not exceed the depth of the plastic deformation region.

2. A method for producing SiC extended ingot in which single SiC ingots that have been ground into a cylindrical shape are bonded and extended in an axial direction by using the method for grinding semiconductor crystal according to claim 1, the method comprising:
a grinding step of grinding an end face of the single SiC ingot into a mirror surface; and
a bonding step of bonding end surfaces of the SiC ingots that have been ground to mirror surfaces by the grinding step;
wherein the single SiC ingots are extended in the axial direction by the bonding step; and
the grinding step is **characterized in that**,
when a plastic deformation region is formed in an end surface of the SiC ingot on the grinding plate side by a temperature increase caused by friction due to intervention of a diamond grindstone between the surface and the grinding plate, on the basis of:
(1) the grain size of the diamond grindstone used for grinding;
(2) a pressing force with which the SiC ingot is pressed against the grinding plate via a support table; and
(3) an advance rate of the support table with respect to the grinding plate,
grain sizes exceeding the width of the plastic deformation region are not used as the grain size of the diamond grindstone, and the advance rate does not exceed the depth of the plastic deformation region.

3. The method of claim 2, wherein
the single SiC ingot has a notch cut into a side surface thereof; and
in the bonding step, the SiC ingots are extended by bonding end surfaces thereof which have been ground into mirror surfaces in a state where the notches are aligned with each other.
